# EUROPEAN PATENT SPECIFICATION

(11) **EP 2 892 079 B1**
(45) Date of publication and mention of the grant of the patent: **01.12.2021**
(21) Application number: 14200578.4
(22) Date of filing: 30.12.2014
(51) Int. Cl.: H01L 29/78, H01L 21/761, H01L 27/06

(54) **Electronic circuits including a MOSFET and a dual-gate JFET**
Elektronische Schaltungen mit einem MOSFET und einem Dual-Gate-JFET
Circuits électroniques comprenant un MOSFET et un JFET à double grille

(30) Priority: 03.01.2014 US 201461923578 P
(43) Date of publication of application: 08.07.2015
(73) Proprietor: STMicroelectronics International N.V., 1118 BH Schiphol (NL)
(72) Inventor: Masliah, Denis A., Sunnyvale, California 94085 (US); Bracale, Alexandre, Sunnyvale, California 94085 (US)
(74) Representative: Casalonga

(56) References cited:
- US-A1- 2011 241 083
- US-A1- 2013 032 824
- US-A1- 2013 248 945
- None

## Description

### BACKGROUND

### Field of Invention

The present invention relates generally to semiconductor devices and more particularly to semiconductor devices configured for power applications.

### Related Art

US2011/241083 A1 discloses Transistors employing floating buried layers may be susceptible to noise coupling into the floating buried layers. In IGFETS this is reduced or eliminated by providing a normally-ON switch coupling the buried layer and the IGFET source or drain. When the transistor is OFF, this clamps the buried layer voltage and substantially prevents noise coupling thereto. When the drain-source voltage VDS exceeds the switch's threshold voltage Vt, it turns OFF, allowing the buried layer to float, and thereby resume normal transistor action without degrading the breakdown voltage or ON-resistance.

US 2013/248945 A1 concerns electronic circuits and methods are provided for various applications including signal amplification. An exemplary electronic circuit comprises a MOSFET and a dual-gate JFET in a cascode configuration. The dual-gate JFET includes top and bottom gates disposed above and below the channel. The top gate of the JFET is controlled by a signal that is dependent upon the signal controlling the gate of the MOSFET. The control of the bottom gate of the JFET can be dependent or independent of the control of the top gate. The MOSFET and JFET can be implemented as separate components on the same substrate with different dimensions such as gate widths. In particular, this document discloses in relation with Fig. 8B a device corresponding to the device shown in Fig. 17 of the present application. The invention as defined in appended claim 1 differs from this device in that the first source and the second drain are formed outside the second well.

Complementary metal-oxide semiconductor (CMOS) devices designed for radio-frequency (RF) power applications have traditionally required a tradeoff between improved RF performance versus a higher breakdown voltage. For example, the RF performance of a CMOS device may be improved by reducing gate geometries (e.g., by using short channel lengths). A smaller gate geometry, however, reduces the breakdown voltage of the CMOS device. Because the reduced breakdown voltage limits the voltage swing available at the output of the CMOS device in an amplifier configuration, such CMOS devices are less useful in power applications.

In one approach to the breakdown voltage problem, CMOS devices may be designed for greater current drive with a lower voltage swing. Greater current drive may, however, require the width of a transistor in the CMOS device to be made large thus presenting an undesired capacitive load to the driving circuit.

Another approach to the breakdown voltage problem uses Laterally Diffused Metal-Oxide-Semiconductor (LDMOS) transistors. LDMOS transistors have a drift region between an active region and a drain. The drift region is lightly doped and experiences the largest voltage swings. Because the doping concentration in the drift region is limited by the breakdown voltage requirements, LDMOS devices tradeoff a higher breakdown voltage for a higher total resistance of the drain-current flowing between the drain and the source terminals (known as the on-state resistance).

Another approach to the breakdown voltage problem uses devices with thicker and higher resistivity substrates. These devices may offer higher-voltage performance but also introduce higher on-state losses. These devices include Reduced Surface Field (RESURF) devices in which the depletion region of the substrate diode interacts with the depletion region of the lateral diode to reduce the surface field. In these devices, the voltage breakdown is increased because of the lateral widening of the depletion zone.

There is, therefore, a need for a high breakdown voltage semiconductor device that provides improved RF capability and higher power as compared to conventional semiconductor devices.

### SUMMARY

According to the invention a MOS device according to claim 1 is provided.

The present invention provides various electronic circuits for use as power amplifiers for amplifying input signals. An exemplary circuit comprises a MOSFET and a JFET, both including a source and a drain, where the source of the JFET is directly coupled to the drain of the MOSFET. The MOSFET also includes a gate, while the JFET also includes both a top gate and a bottom gate. The gates of the MOSFET and of the JFET, in some embodiments, have different widths. The source and drain of both the MOSFET and JFET, and the top and bottom gates of the JFET, are defined within the substrate, while the gate of the MOSFET gate is disposed on the substrate. In some instances the substrate comprises a silicon on insulator wafer having a silicon layer over an insulator layer, and in these embodiments the features defined within the substrate are defined within the silicon layer.

In various embodiments the top gate of the JFET is coupled to the gate of the MOSFET. In some of these embodiments the bottom gate of the JFET is also coupled to the gate of the MOSFET, and in some of these embodiments the top and bottom gates of the JFET are both coupled to a DC bias source.

In various embodiments of the exemplary circuit the top gate of the JFET is coupled to the bottom gate of the JFET and both gates are independent of the gate of the MOSFET. In some of these embodiments the top and bottom gates of the JFET are both coupled to a DC bias source, while in other of these embodiments the top and bottom gates of the JFET are both coupled to ground. In still further of these embodiments the top gate of the JFET is coupled to a first DC bias source and/or the bottom gate of the JFET is coupled to a second DC bias source or ground.

The present application also discloses various devices, not forming part of the claimed invention, but useful for understanding it. An exemplary device comprises a transceiver coupled to a power amplifier as set forth above. The transceiver, in various embodiments, is configured to produce a signal having a frequency in the range of about 700MHz to about 2.5GHz or to produce a signal having a frequency in the range of about 150MHz to about 6GHz. In some examples the transceiver is disposed on a same substrate as the MOSFET and the JFET. Various examples further comprise an output matching circuit coupled to the drain of the JFET.

Further, the present application also discloses methods for signal amplification, not forming part of the claimed invention, but useful for understanding it. An exemplary method comprises controlling a gate of a MOSFET with a first signal, controlling a top gate of a JFET with a second signal, and controlling a bottom gate of the JFET with a third signal, where the JFET is in a cascode configuration with the MOSFET. In various examples the second signal is dependent on the first signal and in some of these examples the third signal is dependent on the second signal. Similarly, in various embodiments the second signal is independent on the first signal and in some of these examples the third signal is dependent on the second signal.

The present disclosure further provides methods of making electronic circuits, the methods not forming part of the claimed invention, but useful for understanding it. An exemplary method comprises providing a silicon on insulator wafer having a silicon layer over an insulator layer embedded within the wafer, defining within the silicon of the wafer, such as by ion implantation, a MOSFET including a source and a drain defining within the silicon of the wafer a JFET including a source, a drain, a top gate, and a bottom gate, and forming a gate of the MOSFET on the silicon, such as by photolithography. In various examples the method further includes forming a metal layer in electrical communication with both the source of the JFET and the drain of the MOSFET so that the source of the JFET is directly coupled to the drain of the MOSFET.

Another exemplary circuit disclosed herein and not forming part of the claimed invention, but useful for understanding it comprises a MOS device formed substantially in a substrate. The substrate includes a first well defined within the substrate, where the well is characterized by a top surface formed, for example, by planarizing the substrate. Defined within the well are a bottom gate, a first channel defined between the bottom gate and the top surface, a first drain, a second drain between the first drain and the source, a first gate between the first and second drains, and a gap between the source and the second drain. The MOS device further comprises a dielectric layer disposed above the top surface of the first well and aligned with the gap and a second gate disposed above the dielectric layer. In the exemplary MOS device the first gate controls the first channel and the second gate controls a second channel, also disposed within the first well. The first and second channels are doped differently, such that when one is doped to be n-type, the other is doped to be p-type.

The claimed MOS device includes two sidewalls defined in the first well such that both sidewalls are joined to the bottom gate. A second well is defined within the first well by a volume enclosed between the two sidewalls and between the bottom gate and the top surface. In one configuration, one of the two sidewalls is disposed between the first and second gates such that the first source, second gate, and second drain comprise a MOSFET in a third well on one side of the one sidewall. In these embodiments, the first well also includes, defined therein, a second source disposed between the one side wall and the first gate. The second source, first gate, and first drain are all within the second well, and together with the bottom gate and first channel comprise a dual-gate JFET. In these embodiments, the one sidewall is disposed between the second source and the second drain and therefore the MOSFET and JFET are electrically coupled from the second drain to the second source by a conductive path defined above the top surface, such as a metal trace disposed on the substrate. The sidewalls have the same doping as the bottom gate. At least one sidewall is exposed at the top surface to allow a voltage to be applied to the bottom gate.

According to the claimed invention, the two sidewalls are disposed such that the first source, first and second drains, first gate, and first channel are all disposed within the second well. These embodiments do not include the second source, nor the third well. Rather, the first channel provides electrical conduction between the second drain and the first drain and is controlled by the first gate, and a second channel disposed within the second well provides electrical conduction between the first source and the second drain and is controlled by the second gate. The second channel is disposed between the bottom gate and the second gate. As noted, the first and second channels are doped such that when one is doped to be n-type, the other is doped to be p-type, therefore, opposing sides of the second well are doped with one side n-type and the other side p-type that meet at a boundary interface that extends between the second drain and the bottom gate.

### BRIEF DESCRIPTION OF THE DRAWINGS

Elements in the figures are illustrated for simplicity and clarity and are not drawn to scale. The dimensions of some of the elements may be exaggerated relative to other elements to help improve the understanding of various embodiments of the
Figs. 1-17 show examples not falling under the scope of the claimed invention and Fig. 18 shows an embodiment according to the claimed invention.
FIG. 1 illustrates an exemplary cross section of a double-gate semiconductor device comprising a MOS gate, a junction gate and two adjacent N+ regions, according to an example not forming part of the claimed invention.
FIG. 2 illustrates an exemplary cross section of a double-gate semiconductor device comprising a MOS gate, a junction gate and two N+ regions coupled using a conducting layer, according to an example not forming part of the claimed invention.
FIG. 3 illustrates an exemplary cross section of a double-gate semiconductor device comprising a MOS gate, a junction gate, and a single N+ region disposed between the MOS gate and the junction gate, according to an example not forming part of the claimed invention.
FIG. 4 illustrates an exemplary cross section of the double-gate semiconductor device of FIG. 3 in a second mode of operation, according to an example not forming part of the claimed invention.
FIG. 5 illustrates an exemplary circuit diagram of the double-gate semiconductor devices of FIGs. 1-3 and 6, according to an example not forming part of the claimed invention.
FIG. 6 illustrates an exemplary cross section of a double-gate semiconductor device comprising a MOS gate and a junction gate, according to an example not forming part of the claimed invention.
FIG. 7 provides a circuit diagram for an exemplary electronic circuit comprising a MOSFET and a dual-gate JFET, according to an example not forming part of the claimed invention.
FIGs. 8A, 8B, and 8C are cross sections of exemplary electronic circuits, each comprising a MOSFET and a dual-gate JFET where the MOSFET and the JFET are distinct, according to three examples not forming part of the claimed invention.
FIGs. 9-15 provide circuit diagrams for several exemplary electronic circuits comprising a MOSFET and a dual-gate JFET, according to various examples not forming part of the claimed invention.
FIG. 16 provides a flowchart representation of an exemplary method for amplifying a signal with a MOSFET and a dual-gate JFET in a cascode configuration.
FIG. 17 is a cross sectional view of a MOS device according to an example.
FIG. 18 is a cross sectional view of a MOS device according to an exemplary embodiment of the present invention.

### DETAILED DESCRIPTION

The present disclosure is directed to double-gate semiconductor devices characterized by high breakdown voltages that allow for a large excursion of the output voltage, making these semiconductor devices useful for power applications, such as power amplification. The double-gate semiconductor devices disclosed herein comprise a metal-oxide-semiconductor (MOS) gate and a junction gate, in which the bias of the junction gate may be a function of the gate voltage of the MOS gate. The breakdown voltage of such a double-gate semiconductor device is the sum of the breakdown voltages of the MOS gate and the junction gate. Because an individual junction gate has an intrinsically high breakdown voltage, the breakdown voltage of the double-gate semiconductor device is higher than the breakdown voltage of an individual MOS gate.

The double-gate semiconductor device provides improved RF capability in addition to operability at higher power levels as compared to conventional complementary metal-oxide semiconductor (CMOS) devices. The double-gate semiconductor device may be fabricated substantially on and/or in a substrate using techniques of semiconductor fabrication known in the art and may use standard fabrication processes for CMOS and logic devices with minor modifications in the process flow.

A MOS gate includes a metal-oxide-semiconductor structure that, when a voltage is applied to the MOS gate, modifies the charge distribution in a semiconductor structure, thus controlling the conductive characteristics of the semiconductor structure. The MOS gate can thus function as an electrically-controlled gate or switch. This type of gate is found in a metal-oxide-semiconductor field effect transistor (MOSFET) device. A junction gate includes a region of a channel of semiconductor material that has doping characteristics that are opposite that of the rest of the channel such that when a voltage is applied to the junction gate the charge distribution in the channel is modified and thereby controls the conductive characteristics of the channel. The junction gate can thus function as an electrically-controlled gate or switch. This type of gate is found in a junction field effect transistor (JFET). The effective resistance of the junction gate is the resistance of the channel as controlled by the voltage of the junction gate.

Double-gate semiconductor devices disclosed herein may be fabricated to include one or more implantation regions between the MOS gate and the junction gate. Examples without an implantation region between the MOS gate and the junction gate may provide a higher spatial density configuration for the double-gate semiconductor device than embodiments that include one or more implantation regions between the MOS gate and the junction gate. The principles of operation of these various examples are similar, except that a depletion region between the MOS gate channel and a drift region is modified.

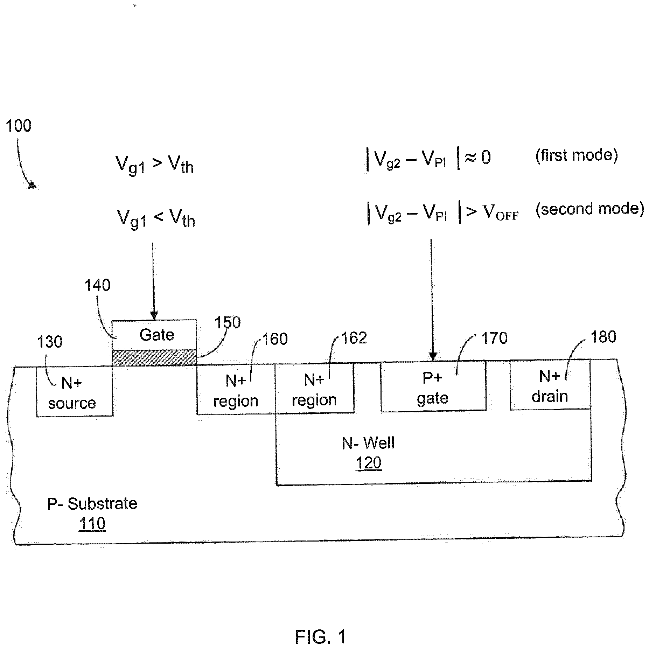

FIG. 1 illustrates an exemplary cross section of a double-gate semiconductor device comprising a MOS gate, a junction gate and two adjacent N+ regions (i.e., implantation regions). Double-gate semiconductor device 100 may be formed from regions and/or layers of doped silicon, polysilicon, metal, and insulating layers using semiconductor fabrication techniques known in the art. It will be understood that the term, "oxide layer," as used herein, is a term of art that refers to any suitable insulating layer for use as the barrier layer in the MOS device, whether or not it happens to include oxygen. This term of art came about because the layer was traditionally formed of silicon dioxide, but in more recent years has come to also be fabricated from other materials, such as low-k dielectric materials, some of which do not include oxygen.

Double-gate semiconductor device 100 comprises P- substrate 110, a N- well 120 formed in the P- substrate 110, N+ source 130, gate 140, oxide layer 150, N+ region 160, N+ region 162, P+ gate 170, and N+ drain 180. As used herein, the "+" symbol indicates strong doping of the conductivity type indicated (e.g., N+ indicating N type, strong doping) and the "―" symbol indicates weak doping of the conductivity type indicated (e.g., P- indicating P type, weak doping).

Electrical signals, such as V_{g1} and control voltage V_{g2}, may be coupled to gate 140 and P+ gate 170, respectively. Electrical signals may also be coupled to N+ source 130, N+ region 160, N+ region 162 and N+ drain 180 using additional polysilicon layers (not shown) or metal layers (not shown) disposed on a surface of each of the N+ source 130, N+ region 160, N+ region 162 and N+ drain 180 using semiconductor fabrication techniques known in the art.

Double-gate semiconductor device 100 includes an N-type MOS Field Effect Transistor (also known as a N-channel MOSFET) formed by P- substrate 110, N+ source 130, and N+ region 160, gate 140, and oxide layer 150. The double-gate semiconductor device 100 also includes an N-channel Junction Field Effect Transistor (also known as an N-type JFET) formed by P- substrate 110, N- well 120, N+ region 162, P+ gate 170 and N+ drain 180. In this embodiment, N+ region 160 and N+ region 162 are adjacent and N+ region 162 is disposed substantially in N- well 120.

Alternatively, the elements of the double-gate semiconductor device 100 may be configured so that the double-gate semiconductor device 100 comprises a P-type MOS gate including a P-channel junction gate. In such an embodiment, some of the regions and/or layers of doped silicon may have a different doping, according to semiconductor fabrication techniques known in the art.

The double-gate semiconductor device 100 may be considered to operate in two modes. A first mode, illustrated in FIG. 1, is indicated by V_{g1} > a threshold voltage Vₜₕ and | V_{g2} - V_{PI} | ≈ 0 (i.e., the absolute value of V_{g2} - V_{PI} is approximately 0). V_{g1} is a voltage at the gate 140, V_{g2} is a voltage at the P+ gate 170, Vₜₕ is a threshold voltage for the gate 140, and V_{PI} is a voltage at N+ region 162. In the first mode a voltage V_{g1} is applied to gate 140 that is greater than Vₜₕ so that the MOS gate is "on." A control voltage V_{g2} is applied to P+ gate 170 so that the junction gate is biased with a low potential difference between control voltage V_{g2} and a voltage V_{PI} of the N+ region 162. The P+ gate 170 thus presents a low resistance, Rₒₙ, to the current flow. In the first mode, the semiconductor device 100 conducts a current between N+ source 130 and N+ drain 180. In the second mode, the semiconductor device 100 does not conduct the current.

Returning to FIG. 1, in the second mode a negative control voltage V_{g2} is applied to P+ gate 170 and the depletion region under P+ gate 170 extends into a channel (not shown) in N― well 120. When the control voltage V_{g2} applied to P+ gate 170 is such that | V_{g2} - V_{PI} | is greater than a pinch off voltage, V_{off} , the channel is fully depleted under the P+ gate 170 and no current flows between the N+ region 162 and N+ drain 180. Likewise, in the second mode, no current flows between N+ source 130 and N+ drain 180.

When a control voltage V_{g2} is applied to P+ gate 170 such that | V_{g2} - V_{PI} | ≈ 0 (corresponding to the first mode), the channel is open and a current of majority carriers may flow between N+ region 162 and N+ drain 180. The P+ gate 170 (the junction gate) may, therefore, behave equivalently to a variable resistor with a high effective resistance, R_{off}, that allows little or no current flow between N+ source 130 and N+ drain 180 when | V_{g2} - V_{PI} | > V_{off}, and a low effective resistance, Rₒₙ, allowing maximum current flow when | V_{g2} - V_{PI} | ≈ 0.

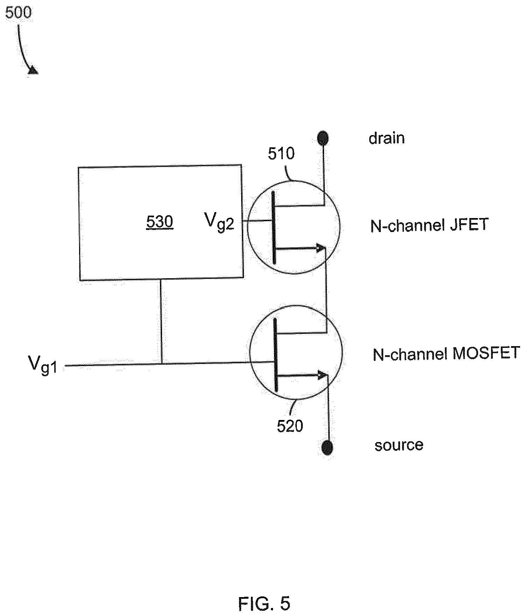

The double-gate semiconductor device 100 may include a device with a double gate in which the control voltage V_{g2} at P+ gate 170 (the junction gate) may be a function of the voltage V_{g1} at gate 140 (the MOS gate). The MOS gate and the junction gate may both be dynamically biased in the "on" state or "off" state at the same time using a control circuitry described with reference to FIG. 5.

The high effective resistance, R_{off}, in the second mode of operation allows the P+ gate 170 to sustain a high voltage and limits the voltage potential between gate 140 and N+ region 160 to less than the MOS gate breakdown voltage. Because the breakdown voltage of the double-gate semiconductor device 100 is the sum of the breakdown voltages of the MOS gate and the P+ gate 170, the intrinsically high breakdown voltage of the P+ gate 170 provides the high breakdown voltage of the double-gate semiconductor device 100.

The control voltage V_{g2} may be adjusted using the control circuitry and may depend on the pinch-off voltage, V_{off} . The control circuitry may comprise a capacitor (not shown) configured to couple a RF signal from gate 140 to P+ gate 170. To limit the distance between gate 140 and P+ gate 170, the capacitor may be implemented with multiple stacked metal layers in parallel between the gate 140 and P+ gate 170.

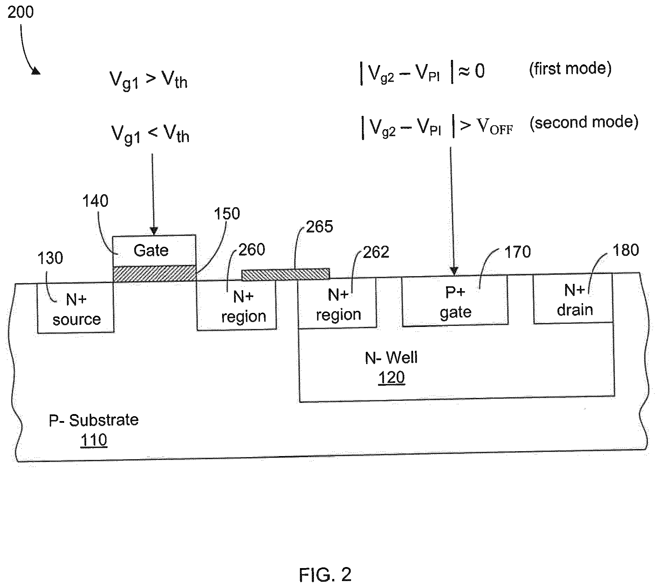

FIG. 2 illustrates an exemplary cross section of a double-gate semiconductor device comprising a MOS gate, a junction gate and two N+ regions coupled using a conducting layer. Double-gate semiconductor device 200 may be formed from regions and/or layers of doped silicon, polysilicon, metal, and insulating layers using semiconductor fabrication techniques known in the art.

Double-gate semiconductor device 200 comprises P- substrate 110, a N- well 120 formed in the P- substrate 110, N+ source 130, gate 140, oxide layer 150, N+ region 260, N+ region 262, conducting layer 265, P+ gate 170, and N+ drain 180. Conducting layer 265 may be a polysilicon layer, a metal layer or another conducting layer known in the art. As illustrated in FIG. 2, N+ region 260 and N+ region 262 are separated by a region of P- substrate 110, and N+ region 262 is disposed substantially in N- well 120.

As discussed herein with respect to double-gate semiconductor device 200, electrical signals, such as V_{g1} and control voltage V_{g2}, may be coupled to gate 140 and P+ gate 170, respectively. Electrical signals may also be coupled to N+ source 130, N+ region 260, N+ region 262 and N+ drain 180 using additional polysilicon layers (not shown) or metal layers (not shown) disposed on a surface of each of the N+ source 130, N+ region 260, N+ region 262 and N+ drain 180 using semiconductor fabrication techniques known in the art.

Double-gate semiconductor device 200 includes an N-type MOSFET formed by P- substrate 110, N― well 120, N+ source 130, and N+ region 260, gate 140, and oxide layer 150. The double-gate semiconductor device 200 also includes an N-channel JFET formed by P- substrate 110, N- well 120, N+ region 262, P+ gate 170 and N+ drain 180. In this embodiment, N+ region 260 and N+ region 262 are coupled using conducting layer 265.

Alternatively, the elements of the double-gate semiconductor device 200 may be configured so that the double-gate semiconductor device 200 comprises a P-type MOS gate including a P-channel junction gate or an N-type MOS gate including a P-channel junction gate or a P-type MOS gate including a N-channel junction gate. In such an example, some of the regions and/or layers of doped silicon may have a different doping, according to semiconductor fabrication techniques known in the art.

The double-gate semiconductor device 200 may be considered to operate analogously to the two modes as described herein with respect to FIG. 1. A first mode is indicated by V_{g1} > a threshold voltage Vₜₕ and | V_{g2} - V_{PI} | ≈ 0, where V_{PI} is a voltage at N+ region 262. In the first mode, a voltage V_{g1} is applied to gate 140 that is greater than Vₜₕ so that the MOS gate is "on." A control voltage V_{g2} is applied to P+ gate 170 so that the junction gate is biased with a low potential difference between control voltage V_{g2} and a voltage V_{PI} of the N+ region 262. The P+ gate 170 thus presents a low resistance, Rₒₙ, to the current flow. In the first mode, the semiconductor device 200 conducts a current between N+ source 130 and N+ drain 180. In the second mode, the semiconductor device 200 does not conduct the current.

When a control voltage V_{g2} is applied to P+ gate 170 such that | V_{g2} - V_{PI} | ≈ 0 (corresponding to the first mode), the channel is open and a current of majority carriers may flow between N+ region 262 and N+ drain 180. The P+ gate 170 (the junction gate) may, therefore, behave equivalently to a variable resistor with a high effective resistance, R_{off}, that allows little or no current flow between N+ source 130 and N+ drain 180 when | V_{g2} - V_{PI} | > V_{off}, and a low effective resistance, Rₒₙ, allowing maximum current flow when | V_{g2} - V_{PI} | ≈ 0.

The double-gate semiconductor device 200 may include a device with a double-gate in which the control voltage V_{g2} at P+ gate 170, the junction gate, may be a function of the voltage V_{g1} at gate 140. The MOS gate and the junction gate may both be dynamically biased in the "on" state or "off" state at the same time using a control circuitry described with reference to FIG. 5. The control circuitry may include a capacitor (not shown) configured to couple a RF signal from gate 140 to P+ gate 170, as described with reference to FIG. 1.

In the second mode of operation, the high effective resistance, R_{off}, allows the P+ gate 170 to sustain a high voltage and limits the voltage potential between gate 140 and N+ region 260 to less than the MOS gate breakdown voltage. Because the breakdown voltage of the double-gate semiconductor device 200 is the sum of the breakdown voltages of the MOS gate and the P+ gate 170, the intrinsically high breakdown voltage of the P+ gate 170 provides the high breakdown voltage of the double-gate semiconductor device 200.

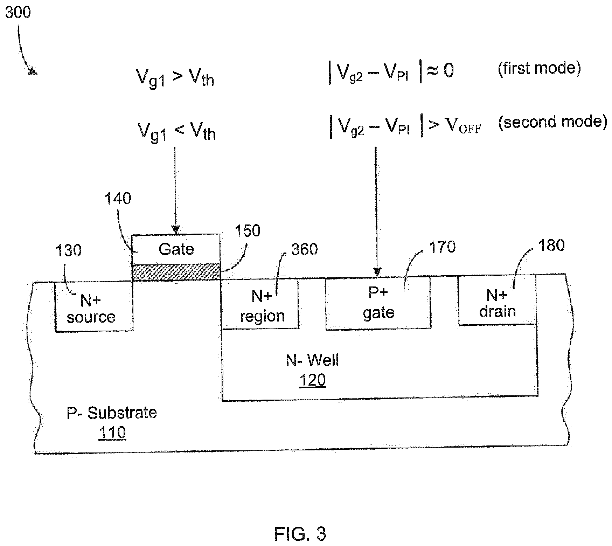

FIG. 3 illustrates an exemplary cross section of a double-gate semiconductor device comprising a MOS gate and a junction gate and a single N+ region disposed between the MOS gate and the junction gate. Double-gate semiconductor device 300 may be formed from regions and/or layers of doped silicon, polysilicon, metal, and insulating layers using semiconductor fabrication techniques known in the art. Double-gate semiconductor device 300 comprises P- substrate 110, a N- well 120 formed in the P- substrate 110, N+ source 130, gate 140, oxide layer 150, N+ region 360, P+ gate 170, and N+ drain 180. As illustrated in FIG. 3, N+ region 360 is disposed substantially in the N- well 120.

As described with reference to FIGs. 1-2, electrical signals, such as V_{g1} and control voltage V_{g2}, may be coupled to gate 140 and P+ gate 170, respectively. Electrical signals may also be coupled to N+ source 130, N+ region 360 and N+ drain 180 using additional polysilicon layers (not shown) or metal layers (not shown) disposed on a surface of each of the N+ source 130, N+ region 360 and N+ drain 180 using semiconductor fabrication techniques known in the art.

Double-gate semiconductor device 300 includes an N-type MOS gate formed by P- substrate 110, gate 140, and oxide layer 150. The double-gate semiconductor device 300 also includes an N-channel JFET formed by P- substrate 110, N- well 120, N+ region 360, P+ gate 170 and N+ drain 180. In this embodiment, the N+ region 360 is a source of the N-channel JFET and abuts the N-type MOS gate, the N-type MOS gate comprising gate 140 and oxide layer 150.

The double-gate semiconductor device 300 may be considered to operate analogously to the two modes as described herein with respect to FIGs. 1-2. A first mode is indicated by V_{g1} > a threshold voltage Vₜₕ and | V_{g2} - V_{PI} | ≈ 0, where V_{PI} is a voltage at N+ region 360. In the first mode a voltage V_{g1} is applied to gate 140 that is greater than Vₜₕ so that the MOS gate is "on." A control voltage V_{g2} is applied to P+ gate 170 so that the junction gate is biased with a low potential difference between control voltage V_{g2} and a voltage V_{PI} of the N+ region 360. The P+ gate 170 thus presents a low resistance, Rₒₙ, to the current flow. In the first mode, the semiconductor device 300 conducts a current between N+ source 130 and N+ drain 180. In the second mode, the semiconductor device 300 does not conduct the current.

When a control voltage V_{g2} is applied to P+ gate 170 such that | V_{g2} - V_{PI} | = 0 (corresponding to the first mode), the channel is open and a current of majority carriers may flow between N+ region 360 and N+ drain 180. The P+ gate 170 (the junction gate) may, therefore, be considered as behaving equivalently to a variable resistor with a high effective resistance, R_{off}, that allows little or no current flow between N+ source 130 and N+ drain 180 when | V_{g2} - V_{PI} | > V_{off}, and a low effective resistance, Rₒₙ, allowing maximum current flow when | V_{g2} - V_{PI} | ≈ 0.

As described with reference to FIGs 1-2, the double-gate semiconductor device 300 may be considered to be a device with a double-gate in which the control voltage V_{g2} at P+ gate 170, the junction gate, may be a function of the voltage V_{g1} at gate 140. The MOS gate and the junction gate may both be dynamically biased in the "on" state or "off" state at the same time using a control circuitry described with reference to FIG. 5. The control circuitry may comprise a capacitor (not shown) configured to couple a RF signal from gate 140 to P+ gate 170, as described with reference to FIG. 1.

In the second mode of operation, the high effective resistance, R_{off}, allows the P+ gate 170 to sustain a high voltage and limits the voltage potential between gate 140 and N+ region 360 to less than the MOS gate breakdown voltage. Because the breakdown voltage of the double-gate semiconductor device 300 is the sum of the breakdown voltages of the MOS gate and the P+ gate 170, the intrinsically high breakdown voltage of the P+ gate 170 provides the high breakdown voltage of the double-gate semiconductor device 300.

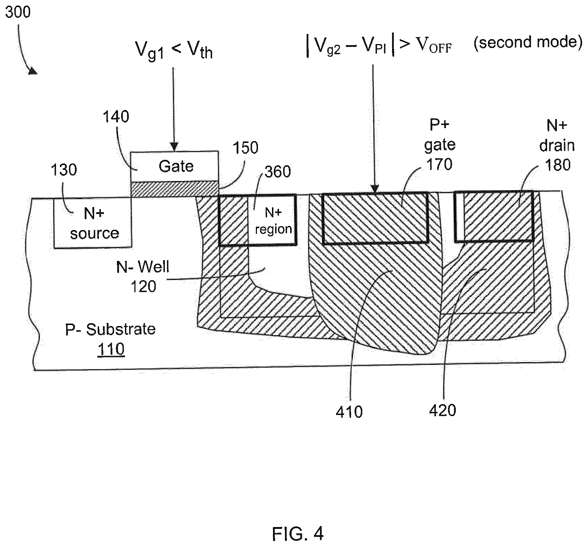

FIG. 4 illustrates an exemplary cross section of the double-gate semiconductor device 300 of FIG. 3 in a second mode of operation. The description herein of the double gate semiconductor device 300 in a second mode of operation applies analogously to the second mode of operation of the double-gate semiconductor devices 100 and 200 described with reference to FIGs. 1-2, respectively.

In the second mode of operation, the voltage V_{g1} applied to gate 140 is lower than the threshold voltage, Vₜₕ, so that the MOS gate is "off." A control voltage V_{g2} is applied to the P+ gate 170 so that the junction gate is biased near the pinch-off voltage, V_{off}, by using a high potential difference between V_{g2} and a voltage V_{PI} of the N+ region 360. The P+ gate 170 thus presents a high effective resistance, R_{off}, to the current flow in a drift region, such as drift region 420 illustrated in FIG. 4. The high effective resistance, R_{off}, results from a depletion region extending under and around the P+ gate 170, such as depletion region 410 illustrated in FIG. 4.

The high effective resistance, R_{off}, in the second mode of operation allows the P+ gate 170 to sustain a high voltage and limits the voltage swing at gate 140 to less than the MOS gate breakdown voltage. The second mode of operation effectively protects the gate 140 from voltages greater than the breakdown voltage. Because the breakdown voltage of the double-gate semiconductor device 300 is the sum of the breakdown voltages of the MOS gate and the P+ gate 170, the intrinsically high breakdown voltage of the P+ gate 170 provides the high breakdown voltage of the double-gate semiconductor device 300.

FIG. 5 illustrates an exemplary circuit diagram of the double-gate semiconductor devices of FIGs. 1-2. The circuit 500 comprises N-channel JFET 510, N-channel MOSFET 520, and control circuitry 530. The control circuitry 530 provides a control voltage V_{g2} to the gate of N-channel JFET 510 that may be a function of the voltage V_{g1} of the N-channel MOSFET 520. The control circuitry 530 functions to dynamically bias both the N-channel MOSFET 520 and N-channel JFET 510 in the "on" state or the "off" state at the same time. Control circuitry 530 may be a capacitor that may couple a RF signal from the gate of the N-channel MOSFET to the gate of the N-channel JFET.

The control circuitry 530 provides the control voltage V_{g2} to bias N-channel JFET 510 so that the R_{off} effective resistance is a maximum value when the N-channel MOSFET is "off" (i.e., V_{g1} < Vₜₕ). Typically, the control voltage V_{g2} biases N-channel JFET 510 close to the pinch-off voltage, V_{off}. When the N-channel MOSFET 520 is "on" (i.e., V_{g1} > Vₜₕ), then control circuitry 530 provides the control voltage V_{g2} to bias N-channel JFET 510 so that the Rₒₙ effective resistance is minimal and the current flow is a maximum. A large range of Rₒₙ to R_{off} effective resistance variation allows a large excursion of voltage at the drain of the N-channel JFET 510 and a corresponding high power capability for the double-gate semiconductor devices described with reference to FIGs. 1-2. The double-gate semiconductor devices described with reference to FIGs. 1-2 may also be represented by a circuit diagram similar to circuit 500 in which N-channel junction gate 510 may be substituted with a P-channel junction gate (not shown) and N-channel MOS gate 520 may be substituted with a P-channel MOS gate (not shown).

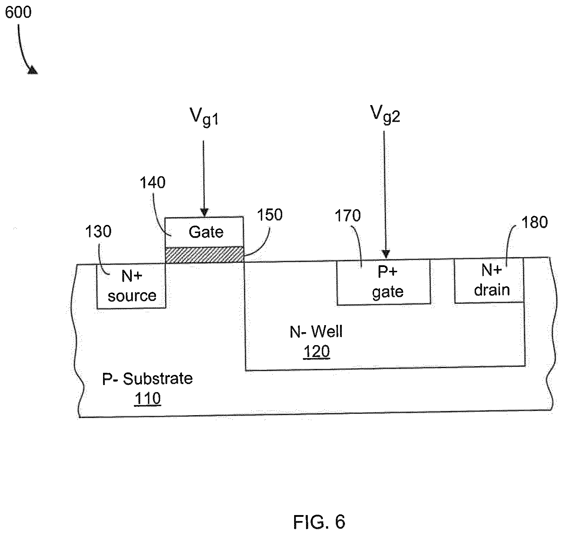

FIG. 6 illustrates a cross section of a double-gate semiconductor device, according to an alternative example not forming part of the claimed invention invention. In this example, the double-gate semiconductor device 600 may be fabricated in a higher spatial density configuration than the examples described with reference to FIGs. 1-4. As illustrated in FIG. 6, double-gate semiconductor device 600 does not include a N+ region such as the N+ region 160, N+ region 162, N+ region 260, N+ region 262 and N+ region 360 described with reference to FIGs. 1-4. Thus, the double-gate semiconductor device 600 is fabricated without the common implantation of an N+ region between the MOS gate and the junction gate. The principle of operation of the double-gate semiconductor device 600 is analogous to the principles of operation of the double-gate semiconductor devices 100, 200 and 300 described with reference to FIGs. 1-3, including the description of the second mode of operation described with reference to FIG. 4.

Double-gate semiconductor device 600 may be formed from regions and/or layers of doped silicon, polysilicon, metal, and insulating layers using semiconductor fabrication techniques known in the art. The double-gate semiconductor device 600 comprises P- substrate 110, a N- well 120 formed in the P- substrate 110, N+ source 130, gate 140, oxide layer 150, P+ gate 170 and N+ drain 180.

Electrical signals, such as V_{g1} and control voltage V_{g2}, may be coupled to gate 140, and P+ gate 170, respectively. Electrical signals may be coupled to N+ source 130 and N+ drain 180 using additional polysilicon layers (not shown) or metal layers (not shown) disposed on a surface of each of the N+ source 130 and N+ drain 180 using semiconductor fabrication techniques known in the art.

The double-gate semiconductor device 600 may be considered to operate analogously to the two modes of operation described with reference to FIGs. 1-4. In a first mode, a current conducts between N+ source 130 and N+ drain 180. In a second mode, the current does not conduct. In the first mode, a voltage V_{g1} is applied to gate 140 that is greater than a threshold voltage Vₜₕ (not shown). A control voltage V_{g2} is applied to the P+ gate 170, thus presenting a low effective resistance, Rₒₙ, to the current flow.

In the second mode of operation, the voltage V_{g1} applied to gate 140 is lower than a threshold voltage, Vₜₕ and a control voltage V_{g2} is applied P+ gate 170, thus presenting a high effective resistance, R_{off}, to the current flow. The high effective resistance, R_{off}, results from a depletion region, similar to the depletion region 410 described with reference to FIG. 4, that extends under and around P+ gate 170.

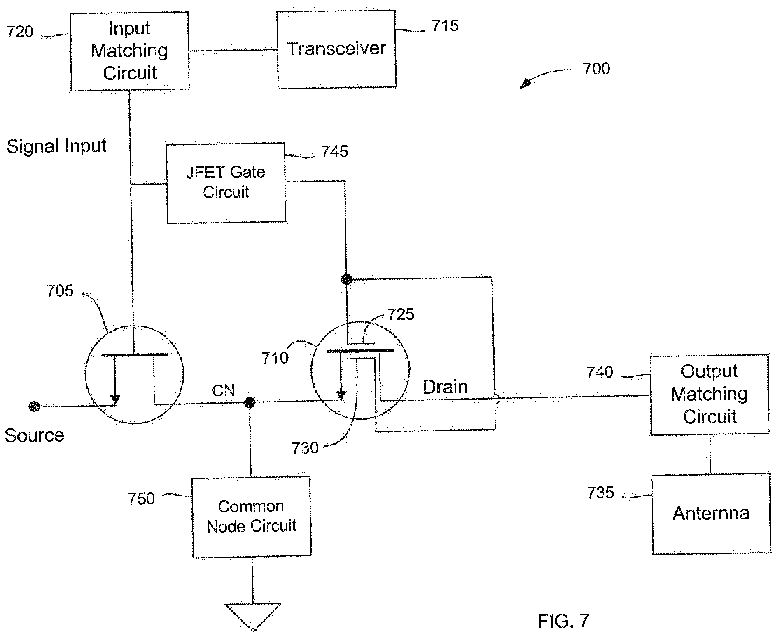

FIG. 7 provides a circuit diagram for an exemplary electronic circuit 700 for amplifying an input signal such as an RF signal. The electronic circuit 700 comprises a MOSFET 705 and a dual-gate JFET 710 in a cascode configuration. In the circuit 700 the JFET 710 functions as a variable resistor.

The MOSFET 705 and dual-gate JFET 710 are distinct transistors. As used herein, two transistors are defined as distinct unless the transistors share a common implantation region. As an example, N+ regions 260 and 262 (FIG. 2) are drain and source, respectively, of distinct transistors. As another example, N+ regions 160 and 162 (FIG. 1) are drain and source, respectively, of transistors that are not distinct since the two share a N+ implantation region.

The MOSFET 705 includes a drain and a source, and in operation the source is coupled to a power supply such as V_{DD}. The MOSFET 705 is controlled by a gate which, in operation, receives an input signal, for example an RF signal, from a signal source such as transceiver 715. Various examples of circuit 700 include an input matching circuit 720 between the transceiver 715 and the gate of the MOSFET 705 to match the impedances on either side thereof. An exemplary matching circuit 720 comprises a capacitor and an inductor where the capacitor is coupled between ground and a node between the transceiver 715 and the gate of the MOSFET 705, and the inductor is disposed in-line between the node and the gate of the MOSFET 705. In various examples the gate length of the MOSFET 705, i.e. the length of the gate implant located between the source and the drain, is less than one micron. It is noted that gate width is the dimension of the gate in the plane of the substrate measured perpendicular to the gate length. In various examples, the MOSFET 705 can be a NMOSFET or a PMOSFET.

The signal source, such as transceiver 715, is disposed on the same substrate as the MOSFET 705 and the dual-gate JFET 710, in some examples. In further examples, the signal source produces a signal with a frequency in the range of about 700MHz to about 2.5GHz. In further examples, the signal source produces a signal with a frequency in the range of about 150MHz to about 6GHz.

The dual-gate JFET 710 comprises a source and a drain electrically connected by a channel that is controlled by two gates, a top gate 725 and a bottom gate 730 disposed above and below the channel, respectively. In various examples, the dual gate JFET 710 can be a NJFET or a PJFET. In various embodiments the dual-gate JFET 710 comprises a sub-micron gate length. The drain of the dual-gate JFET 710 is coupled to an antenna 735 or another device configured for signal transmission. In some examples the antenna 735 is coupled to the drain of the dual-gate JFET 710 by an output matching circuit 740 formed with passive networks, also provided to match impedances.

The source of the dual-gate JFET 710 is coupled to the drain of the MOSFET 705. In some examples, the source of the dual-gate JFET 710 is directly coupled to the drain of the MOSFET 705. As used herein, "directly coupled" means that there are no active components in electrical communication between the coupled transistors. In some examples, the source of the dual-gate JFET 710 is coupled to the drain of the MOSFET 705 through vias and a trace such as conducting layer 265 (FIG. 2). In some examples a point between the source of the dual-gate JFET 710 and the drain of the MOSFET 705 comprises a common node (CN) point. As shown in FIG. 7, the electronic circuit 700 can also comprise, in some instances, an optional common node circuit 750 coupled between the common node point and ground.

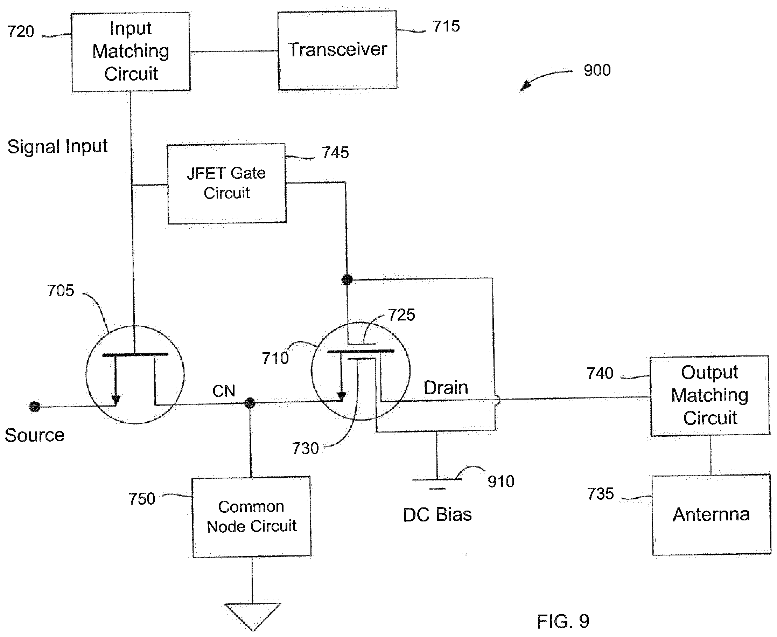

As noted above, the JFET 710 is controlled by a top gate 725 and a bottom gate 730. In various examples, the top and bottom gates 725, 730 are dependent (e.g. commonly controlled) or independent, and can be controlled by ground, a DC bias, the input signal applied to the gate of the MOSFET 705, or the input signal plus a DC bias. Various exemplary ways to control the top and bottom gates 725, 730 are discussed with reference to FIGs. 9-15. In the example provided by FIG. 7, the top and bottom gates 725, 730 are commonly controlled by the output of an optional JFET gate circuit 745 which is analogous to control circuit 530 (FIG. 5).

The JFET gate circuit 745 serves to improve the performance of examples that are used as a power amplifier. The bias of the bottom gate 730 determines the voltage of the top gate 725 to pinch off the JFET 710 where the pinch-off voltage of the JFET 710 is the limit value for the drain of the MOSFET 705. An appropriate value for the bottom gate 730 bias is one that allows that the pinch-off voltage of the JFET 710 to protect the MOSFET 705 in its reliable zone. In some examples the top gate 725 of the JFET 710 is maintained at 0V. But the large gate-to-source and gate-to-drain capacitances couple the large voltage of the drain and of the source onto the gate voltage, reducing the efficiency of the R_{off} and Rₒₙ variation of the JFET 710. The function of the JFET gate circuit 745 is to cancel these signals on the top gate 725 by applying an opposing signal.

As shown in FIG. 7, the electronic circuit 700 can also comprise, in some instances, an optional common node circuit 750 coupled between the common node point and ground. The common node circuit 750 also serves to improve the performance of examples that are used as a power amplifier. The common node circuit 750 compensates for the effect of the gate-to-drain capacitance of the MOSFET 705 and the gate-to-source capacitance of the JFET 710. The common node circuit 750 can be, in some examples, a single inductance or a serial inductor-capacitor (LC) network configured to resonate with the noted capacitances of the MOSFET 705 and the JFET 710 at the particular frequency.

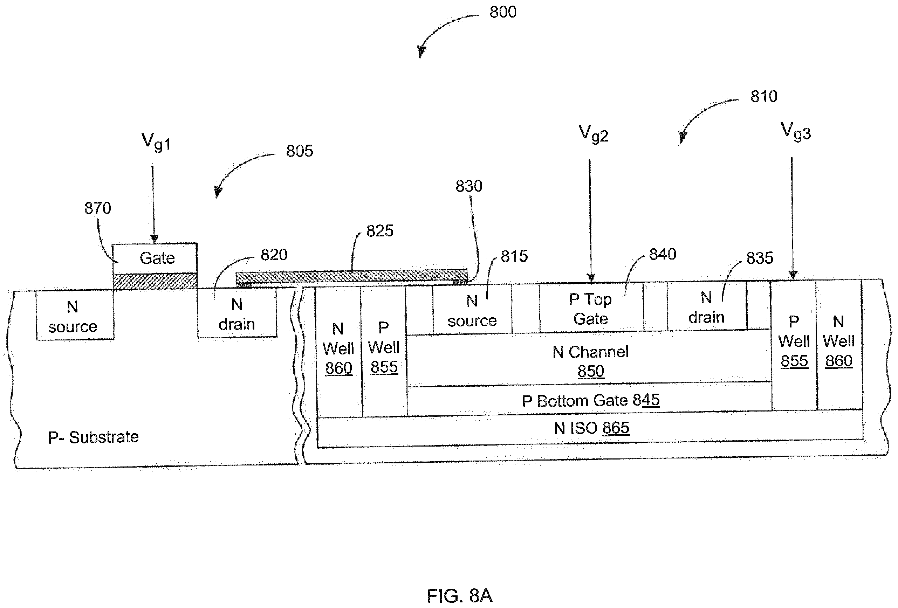

FIG. 8A provides a cross section of an exemplary electronic circuit 800 comprising a MOSFET 805 and a dual-gate JFET 810 where the MOSFET 805 and the JFET 810 comprise distinct transistors. As in previous examples, the MOSFET 805 and the dual-gate JFET 810 can be formed from regions and/or layers of doped silicon, polysilicon, various metals, and various insulating layers using semiconductor fabrication techniques known in the art. In this example, a source 815 of the dual-gate JFET 810 is directly coupled to a drain 820 of the MOSFET 805 by a metal layer 825 and vias 830. As distinct transistors, the MOSFET 805 and a dual-gate JFET 810 can be implemented at different locations on the same substrate and with different dimensions, such as different widths.

The JFET 810 additionally comprises a drain 835, a top gate 840, and a bottom gate 845. The top gate 840 and bottom gate 845 are disposed above and below an N channel 850 that couples the source 815 to the drain 820 of the JFET 810. The bottom gate 845 is bounded by two P wells 855 that provide an electrical connection to the bottom gate 845. The JFET 810 is disposed within an N well region that comprises two N wells 860 and an N isolation layer 865. The P wells 855 also serve to isolate the N channel 850 from the N wells 860 in these examples.

As shown in FIG. 8A, a gate 870 of the MOSFET 805 is controlled by a signal V_{g1}. Similarly, the top gate 840 and bottom gate 845 of the JFET 810 are controlled by signals V_{g2} and V_{g3}, respectively. As noted above, the signal V_{g2} may be dependent upon, or independent of, the signal V_{g1}. Additionally, the signal V_{g3} may be dependent upon, or independent of, the signal V_{g2}.

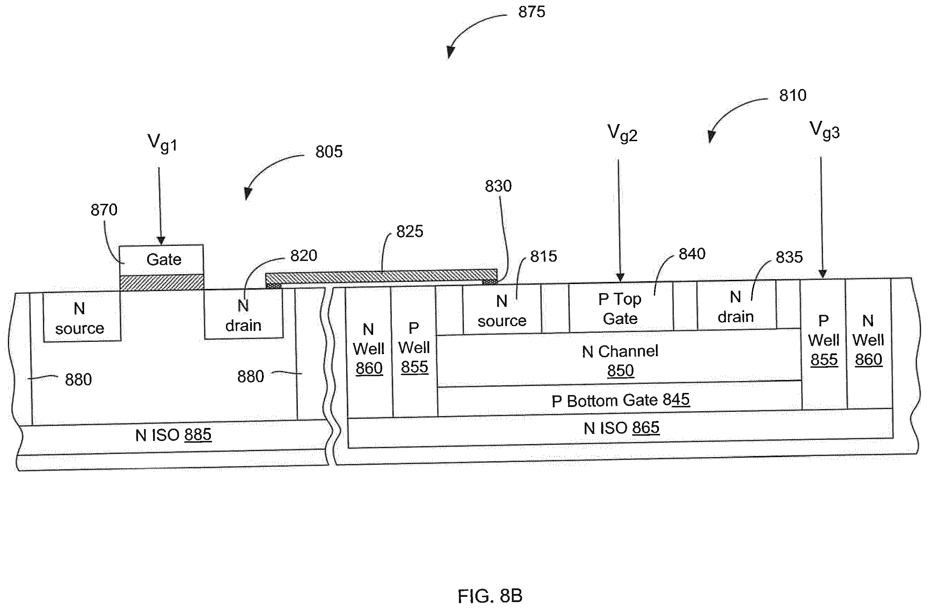

FIG. 8B provides a cross section of another exemplary electronic circuit 875 comprising a MOSFET 805 and a dual-gate JFET 810 where the MOSFET 805 and the JFET 810 comprise distinct transistors. In circuit 875 each of the MOSFET 805 and the dual-gate JFET 810 are disposed within separate N well regions. Here, the N well region within which the MOSFET 805 is disposed is bounded by two N wells 880 and an N isolation layer 885. These examples advantageously isolate the MOSFET 805 from the substrate of the JFET 810.

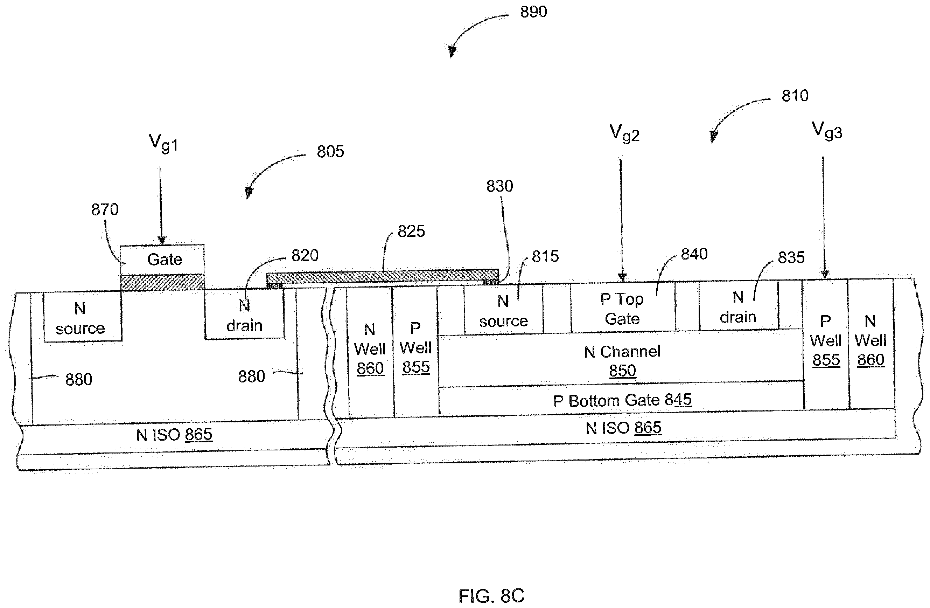

FIG. 8C provides a cross section of another exemplary electronic circuit 890 comprising a MOSFET 805 and a dual-gate JFET 810 where the MOSFET 805 and the JFET 810 comprise distinct transistors. Electronic circuit 890 in FIG. 8C differs from electronic circuit 875 in FIG. 8B in that the N isolation layer 865 is continuous across the entire substrate. Here, the N well region within which the MOSFET 805 is disposed is bounded by the two N wells 880 and the same N isolation layer 865 as bounds the well of the JFET 810.

Examples of electronic circuits illustrated by FIG. 8C can be produced, for example, starting with a substrate having an embedded N isolation layer 865. The substrate can be formed by growing an oxide layer on one surface of a wafer, bonding a second wafer to that surface, and then lapping back the second wafer towards the oxide layer until a desired material thickness above the N isolation layer 865 is achieved; such substrates are commonly referred to as silicon on insulator (SOI) wafers. Various features of the MOSFET 805 and JFET 810 that are defined within the substrate are then formed by ion implantation techniques progressing from the deeper features to the more shallow features. Features formed on the substrate like metal line 825 and gate 870 can be formed by photolithography methods, for example. The examples of electronic circuits illustrated by FIGs. 8A and 8B can be produced, for example, by forming N isolation layer 865 and optionally N isolation layer 885 by ion implantation followed by the formation of the remaining features defined within the substrate by ion implantation and then followed by the formation of those features formed on the substrate by photolithography.

FIG. 9 provides a circuit diagram for an exemplary electronic circuit 900 that comprises the electronic circuit 700 and further comprises a DC bias source 910 coupled to the top and bottom gates 725, 730. In operation, a DC bias voltage is added to the input signal to control the top and bottom gates 725, 730. The DC bias voltage can be positive or negative, in various examples. A negative gate voltage can be applied on the top and bottom gates 725, 730 to decrease the common node voltage, ensuring in this way that the drain of the MOSFET 805 remains in its reliable zone. On the contrary, a positive voltage can be applied on the top and bottom gates 725, 730 to use the complete excursion of the reliable drain voltage to increase performance. In examples such as electronic circuit 900, and in those examples described below, the MOS and JFET gate circuit 745 and the common node circuit 750 are both optional.

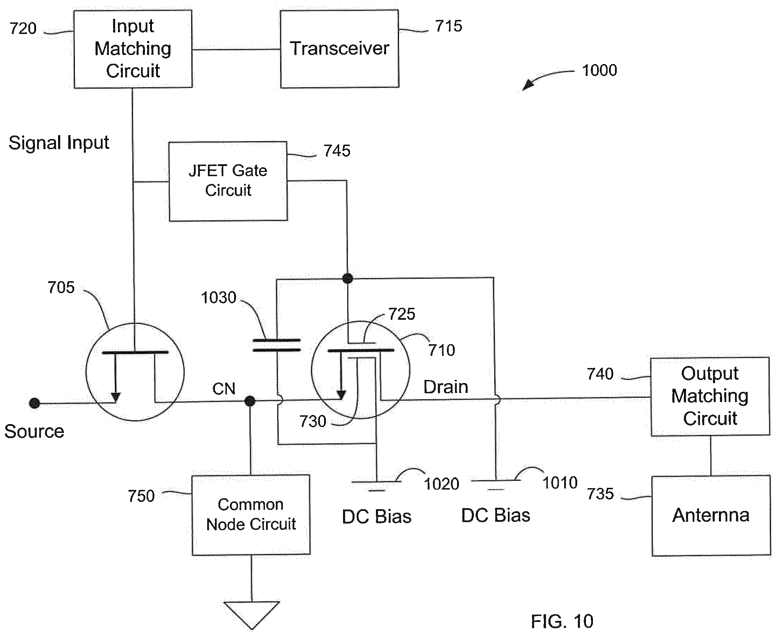

FIG. 10 provides a circuit diagram for an exemplary electronic circuit 1000 that comprises the electronic circuit 700 and further comprises a first DC bias source 1010 coupled to the top gate 725 and a second DC bias source 1020 coupled to the bottom gate 730. In operation, independent DC bias voltages are added to the input signal to independently control each of the top and bottom gates 725, 730. Each DC bias voltage can be positive or negative, in various examples. A capacitor 1030 is added between both top and bottom gates 725, 730 to allow a different DC bias to be applied to each, while applying the same RF coupling to each of the top and bottom gates 725, 730 as is applied to the gate of the MOSFET 705.

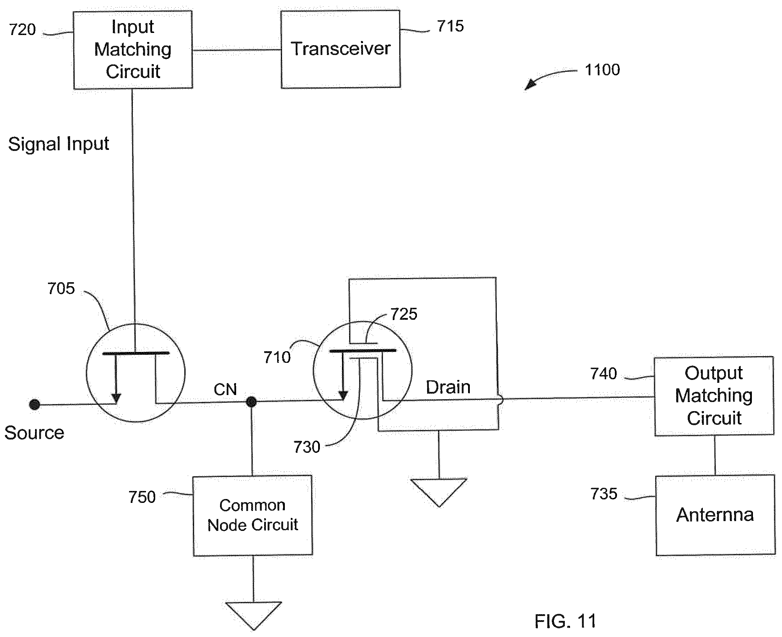

FIG. 11 provides a circuit diagram for an exemplary electronic circuit 1100 that comprises the electronic circuit 700 but without the MOS and JFET gate circuit 745 and wherein the top gate 725 and the bottom gate 730 are both coupled to ground.

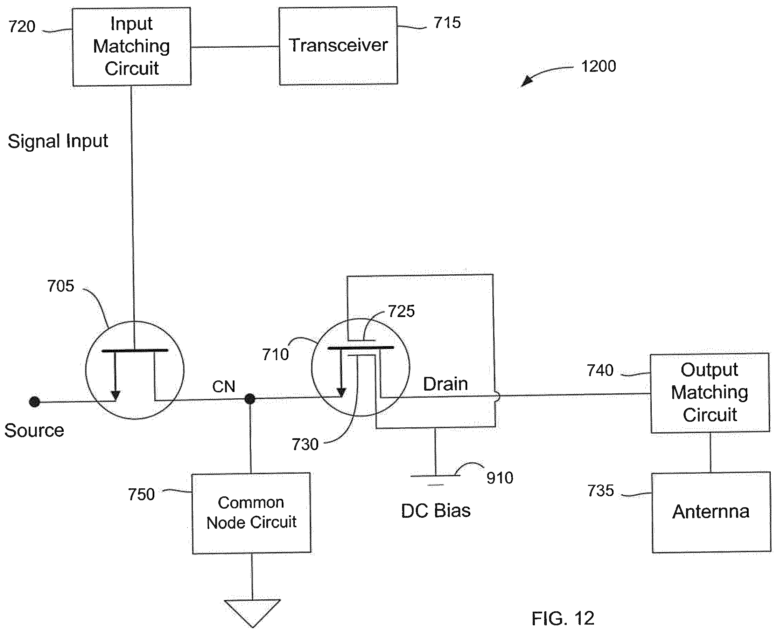

FIG. 12 provides a circuit diagram for an exemplary electronic circuit 1200 that comprises the electronic circuit 700 but without the MOS and JFET gate circuit 745 and wherein the top gate 725 and the bottom gate 730 are both coupled to the DC bias source 910. The DC bias voltage can be positive or negative, in various examples.

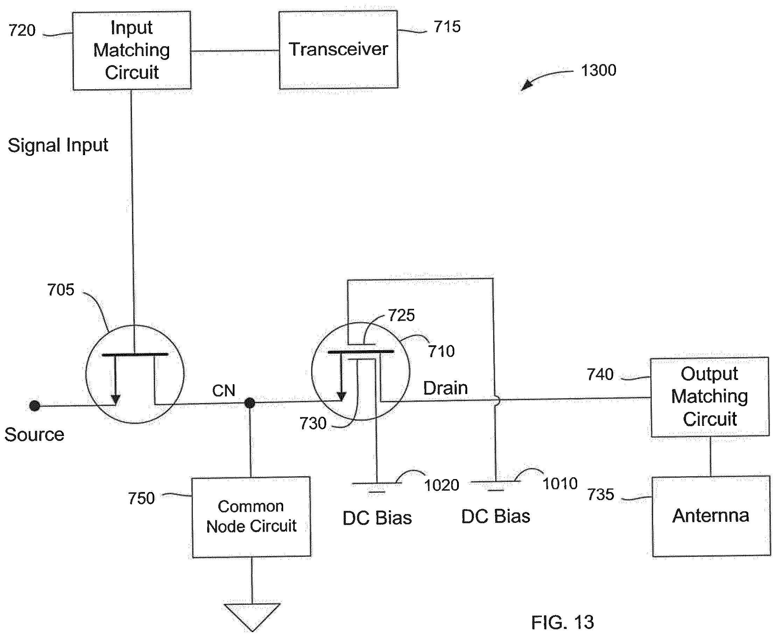

FIG. 13 provides a circuit diagram for an exemplary electronic circuit 1300 that comprises the electronic circuit 700 but without the MOS and JFET gate circuit 745. Additionally, as opposed to FIG. 7, the first DC bias source 1010 is coupled to the top gate 725 and the second DC bias source 1020 is coupled to the bottom gate 730 rather than the top and bottom gates 725, 730 being dependent. Each DC bias voltage can be positive or negative, in various examples. In those examples illustrated by FIGs. 11-13 control of the top and bottom gates 725, 730 is independent of the input signal.

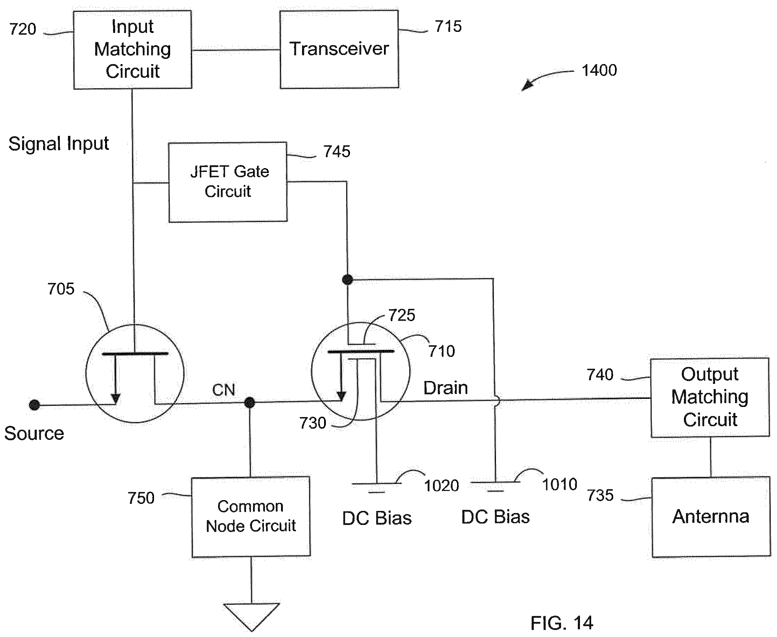

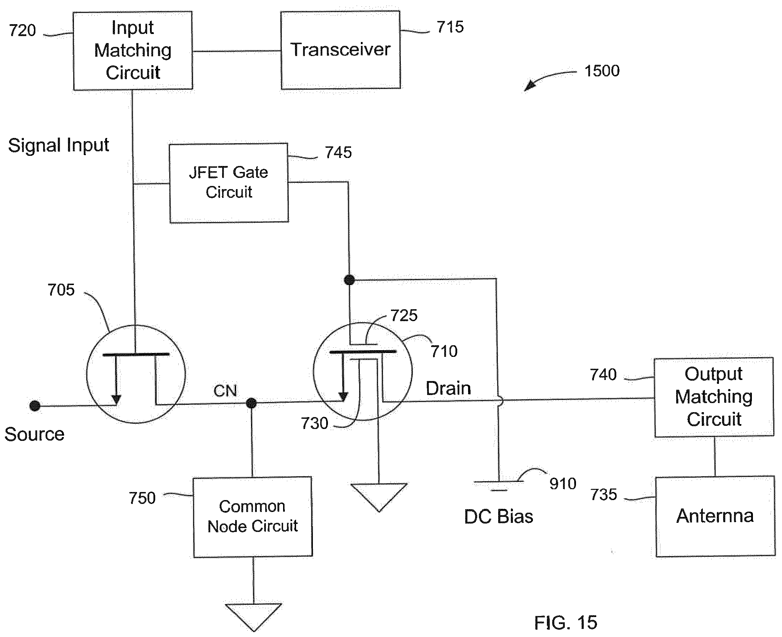

FIG. 14 provides a circuit diagram for an exemplary electronic circuit 1400 that comprises the electronic circuit 1300 and further comprises the MOS and JFET gate circuit 745. FIG. 15 provides a circuit diagram for an exemplary electronic circuit 1500 that comprises the electronic circuit 700, modified such that the bottom gate 730 is independent of the top gate 725, and further comprising the DC bias source 910 coupled to the top gate 725 while the bottom gate 730 is coupled to ground. In those examples illustrated by FIGs. 14 and 15 control of the top gate 725 is dependent upon the input signal while control of the bottom gate 730 is independent of the input signal. An advantage to only applying the RF signal to the top gate 725 of the JFET 710 is that the capacitance between top gate 725 and drain or source terminals is smaller than the capacitances between the bottom gate 730 and the source or drain terminals, and that the top gate 725 is more efficient than the bottom gate 730 for controlling the channel current flow.

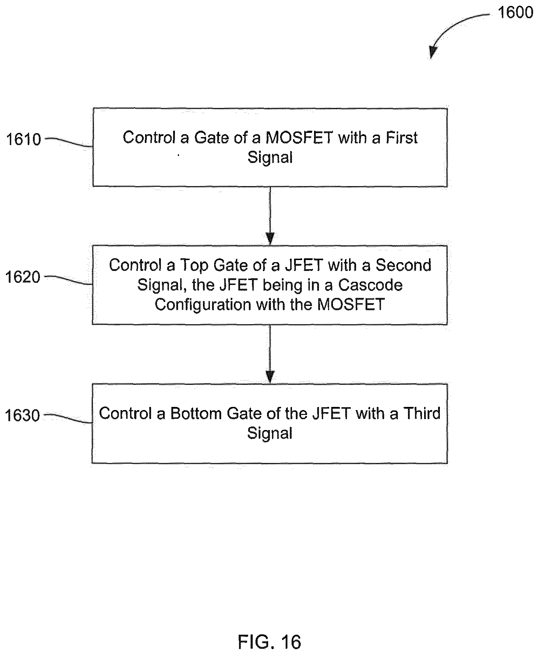

FIG. 16 provides a flowchart representation of an exemplary method 1600 for amplifying a signal with a MOSFET 705 in a cascode configuration with a dual-gate JFET 710. The method comprises a step 1610 of controlling a gate of a MOSFET with a first signal, namely, the input signal to be amplified, a step 1620 of controlling a top gate of a JFET with a second signal, and a step 1630 of controlling a bottom gate of the JFET with a third signal. It will be appreciated that the steps illustrated by FIG. 16 are intended to be performed concurrently.

In various examples, the second signal is dependent upon the first signal and in some of these examples the two signals are the same, for example, where the gate of the MOSFET and the top gate of the JFET are capacitively coupled. In some of these examples the third signal is also dependent on the first and second signals, such as is illustrated by FIG. 7, while in other examples the third signal is independent of the first and second signals, such as in FIGs. 14 and 15.

In various examples the second signal is independent of the first signal, such as is illustrated by FIGs. 11-13. In some of these examples the third signal is dependent upon the second signal while in other examples the third signal is independent of the second signal.

In various examples the first signal comprises the sum of the input signal and a DC bias. Also in various examples either or both of the second and third signals can be a fixed DC bias, either positive or negative, or ground.

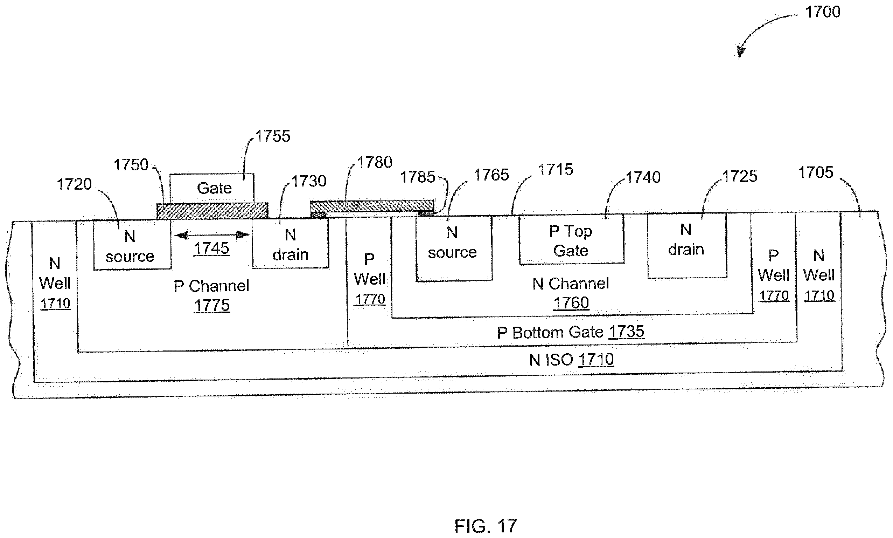

FIG. 17 provides a cross sectional view of still another exemplary MOS device 1700. The MOS device 1700 comprises a substrate 1705 including a first well 1710 defined in the substrate 1705. The first well 1710 is characterized by a top surface 1715 and has, defined therein, a first source 1720, a first drain 1725 and a second drain 1730, a bottom gate 1735, a first top gate 1740. The top surface 1715 is coincident with the top surface of the substrate 1705 and can be formed, for example, by a planarization process. The first well 1710 also includes an isolation structure that isolates the first well 1710 from the remainder of the substrate 1705; the isolation structure comprises an isolation layer disposed parallel to the top surface 1715 and also includes two sidewalls, each joined to an opposing end of the isolation layer, and each extending to the top surface 1715. Depending on context, the term "well" as used herein can refer to either the isolation structure or the entire volume enclosed thereby where the structure and enclosed volume are structurally distinguishable due to different dopings.

The first source 1720 and the second drain 1730 are spaced apart by a gap 1745. The MOS device 1700 also comprises a dielectric layer 1750 disposed above the top surface 1715 of the first well 1710 and aligned with the gap 1745, and also a second top gate 1755 disposed above the dielectric layer 1750 and likewise aligned with the gap 1745. The second top gate 1755 can comprise a conductive material such as polysilicon or a metal, for example. The first well 1710 further includes a first channel 1760 defined between the bottom gate 1735 and the top surface 1715.

In the example of FIG. 17, the bottom gate 1735 is bounded by two sidewalls 1770 each joined to an opposing end of the bottom gate 1735, and at least one sidewall 1770 extending to the top surface 1715. The sidewalls 1770 together with the bottom gate 1735 define a second well disposed within the first well 1710. The first drain 1725, first top gate 1740, first channel 1760, and a second source 1765 are disposed within the second well such that the first top gate 1740 is disposed between the first drain 1725 and the second source 1765. The sidewalls 1770 electrically connect the bottom gate 1735 to the top surface 1715 where at least one electrical contact (not shown) can permit a bias voltage to be applied to the bottom gate 1735. In this example, the first channel 1760 is confined between the sidewalls 1770. The first drain 1725, first top gate 1740, second source 1765, and bottom gate 1735 and first channel 1760 collectively form a JFET in these examples.

In various examples, the substrate 1705 can be silicon having a first doping, for example, P-, the isolation structure of the first well 1710 can have a second doping, such as N-, the bottom gate 1735 can have a third doping, such as P+, the first source 1720, first drain 1725, second drain 1730, and second source 1765 can have a fourth doping such as N+, and the top gate 1740 can have a fifth doping such as P+ which optionally can be the same doping as the third doping of the bottom gate 1735. The remaining material within the second well, including the first channel 1760, can have a sixth doping, such as N- which optionally can be the same doping as the second doping of the first well 1710. The remaining material within the first well 1710 but outside of the second well includes the first source 1720, the second drain 1730, and the gap 1745. This material, with the exception of the first source 1720 and the second drain 1730, can be viewed as a third well disposed within the first well 1710 and have a seventh doping, for example P-, which optionally can be the same doping as the first doping of the substrate 1705. This material, in and around the gap 1745, constitutes a second channel 1775 having the seventh doping. The first source 1720, second drain 1730, second top gate 1755, and second channel 1775 collectively form a MOSFET. The material within the second and third wells are doped such that when one is doped to be n-type the other is doped to be p-type. The third well, in these examples, lacks a defining structure that is analogous to the isolation structure of the first well 1710 and the bottom gate 1735 and sidewalls 1770 of the second well, but can be defined as the portion of the enclosed volume of the first well 1710 that is not within the second well.

In the example of FIG. 17, one sidewall 1770 is disposed between the second drain 1730 and the second source 1765. Material within the second well electrically insulates the second source 1765 from this sidewall 1770, while material within the third well electrically insulates second drain 1730 from this sidewall 1770. Since this sidewall 1770 is insulated from both the second drain 1730 and the second source 1765, electricity cannot flow between them. Rather, the second drain 1730 is directly coupled to the second source 1765 by a metal layer 1780 and vias 1785 to provide an electrical path between them.

Electrical contacts (not shown) disposed on the top surface 1715 provide electrical connections to the gates 1735, 1740, the sources 1720, 1765, the drains 1725, 1730, and optionally the first well 1710. The second gate 1755 is likewise electrically connected by an electrical contact. The gates 1735, 1740, 1755 can be controlled as described in the above examples. The first well 1710 optionally can be biased through the electrical contacts.

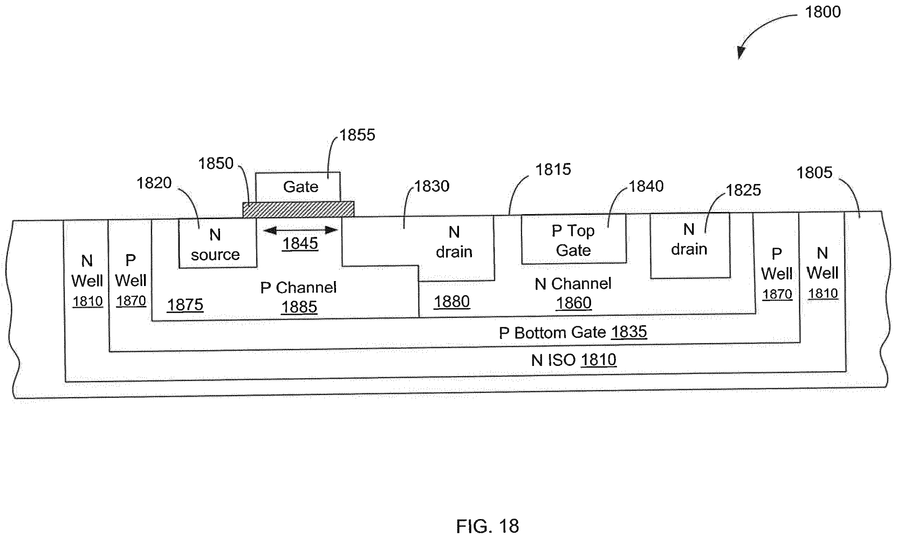

FIG. 18 provides a cross sectional view of an exemplary MOS device 1800 of the present invention. The MOS device 1800 comprises a substrate 1805 including a first well 1810 defined in the substrate 1805. The first well 1810 is characterized by a top surface 1815 and has, defined therein, a first source 1820, a first drain 1825 and a second drain 1830, a bottom gate 1835, and a first top gate 1840. The top surface 1815 is coincident with the top surface of the substrate 1805 and can be formed, for example, by a planarization process. The first well 1810 also includes an isolation structure that isolates the first well 1810 from the remainder of the substrate 1805; the isolation structure comprises an isolation layer disposed parallel to the top surface 1715 and also includes two sidewalls, each joined to an opposing end of the isolation layer, and each extending to the top surface 1815.

The first source 1820 and the second drain 1830 are separated by a gap 1845. The MOS device 1800 also comprises a dielectric layer 1850 disposed above the top surface 1815 of the first well 1810 and aligned with the gap 1845, and also a second top gate 1855 disposed above the dielectric layer 1850 and likewise aligned with the gap 1845. The second top gate 1855 can comprise a conductive material such as polysilicon or a metal, for example. The first well 1810 further includes a first channel 1860 defined between the bottom gate 1835 and the top surface 1815.

The bottom gate 1835 is bounded by two sidewalls 1870 each joined to an opposing end of the bottom gate 1835, and at least one sidewall 1870 extending to the top surface 1815. The sidewalls 1870 together with the bottom gate 1835 define a second well disposed within the first well 1810. The first source 1820, second drain 1830, first top gate 1840, first drain 1825, and first channel 1860 are all disposed within the second well with the first top gate 1840 and second drain 1830 disposed between the first source 1820 and the first drain 1825 and with the first top gate 1840 being disposed between the first and second drains 1825, 1830. The sidewalls 1870 electrically connect the bottom gate 1835 to the top surface 1815 where electrical contacts (not shown) can permit a bias voltage to be applied to the bottom gate 1835.

In various embodiments, the substrate 1805 can be silicon having a first doping, for example P-, the isolation structure of the first well 1810 can have a second doping, the bottom gate 1835 can have a third doping, such as P+, the first source 1820, first drain 1825, and second drain 1830 can have a fourth doping such as N+, and the top gate 1840 can have a fifth doping such as P+ which optionally can be the same doping as the third doping of the bottom gate 1835.

The remaining material within the second well is divided into two regions, a first region 1875 with a sixth doping and a second region 1880 with a seventh doping where the sixth and seventh dopings are opposite types, meaning that when one doping is an n-type doping the other is p-type. The sixth doping can optionally be the same as the first doping and/or the seventh doping can be the same as the second doping. A boundary between the first region 1875 and the second region 1880 within the second well extends between the bottom gate 1835 and the second drain 1830 such that the second drain 1830 makes contact with both regions 1875, 1880. The first channel 1860 is disposed within second region 1880 and can provide conduction between the two drains 1820, 1830. A second channel 1885 is disposed within first region 1875 and can provide conduction between the first source 1820 and the second drain 1830.

Electrical contacts (not shown) disposed on the top surface 1815 provide electrical connections to the gates 1835, 1840, the source 1820, and the drains 1825, 1830. The second gate 1855 is likewise electrically connected. The gates 1835, 1840, 1855 can be controlled as described in the above examples.

## Claims

1. A MOS device comprising:
- a substrate (1805) including a first well (1810) of a first conductivity type defined within the substrate,
- the well having a top surface (1815) and having, defined within the first well: a region of the second conductivity type forming a bottom gate (1835),a first source (1820) of the first conductivity type, a first drain (1825) of the first conductivity type, a second drain (1830) of the first conductivity type between the first drain and the first source, a region of the second conductivity type forming a first gate (1840) disposed at the top surface and between the first drain and the second drain, a first channel (1860) of the first conductivity type defined between the bottom gate and the first gate, wherein the bottom gate is disposed below the first channel, the first channel providing in use conduction between the first drain (1825) and the second drain (1830), a gap (1845) between the first source and the second drain, and a second channel (1885) of the second conductivity type disposed within the first well (1810), the first and second channels having opposite doping types, the second channel providing in use conduction between the first source (1820) and the second drain (1830);
- wherein the MOS device further comprises a dielectric layer (1850) disposed above the top surface of the first well and aligned with the gap; and a second gate (1855) disposed above the dielectric layer and aligned with the gap (1845),
- wherein the MOS device further comprises a first sidewall (1870) and a second sidewall (1870) both of the second conductivity type and defined within the first well (1810) and both joined to an opposing end of the bottom gate (1835), the bottom gate and the two sidewalls defining a second well (1870) within the first well and
- wherein the first source (1820), first and second drains (1825, 1830), and first gate (1840) are all disposed within the second well,
- wherein at least one sidewall (1870) extends to the top surface (1815) and
- wherein the first gate (1840) and the bottom gate (1835) form a dual gate of a JFET.

## Patentansprüche

1. MOS-Bauelement, umfassend:
- ein Substrat (1805), das eine erste Wanne (1810) eines ersten Leitfähigkeitstyps einschließt, die innerhalb des Substrats definiert ist,
- wobei die Wanne eine obere Oberfläche (1815) hat, und innerhalb der ersten Wanne Folgendes definiert ist: ein Bereich des zweiten Leitfähigkeitstyps, der ein unteres Gate (1835) bildet, eine erste Source (1820) des ersten Leitfähigkeitstyps, einen ersten Drain (1825) des ersten Leitfähigkeitstyps, einen zweiten Drain (1830) des ersten Leitfähigkeitstyps zwischen dem ersten Drain und der ersten Source, einen Bereich des zweiten Leitfähigkeitstyps, der ein erstes Gate (1840) bildet, das an der oberen Oberfläche und zwischen dem ersten Drain und dem zweiten Drain angeordnet ist, einen ersten Kanal (1860) des ersten Leitfähigkeitstyps, der zwischen dem unteren Gate und dem ersten Gate definiert ist, wobei das untere Gate unter dem ersten Kanal angeordnet ist, der erste Kanal liefert während dem Betrieb Leitung zwischen dem ersten Drain (1825) und dem zweiten Drain (1830), einen Abstand (1845) zwischen der ersten Source und dem zweiten Drain und einen zweiten Kanal (1885) des zweiten Leitfähigkeitstyps, der innerhalb der ersten Wanne (1810) angeordnet ist, wobei der erste und der zweite Kanal entgegengesetzte Dotierungstypen aufweisen, der zweite Kanal liefert während dem Betrieb Leitung zwischen der ersten Source (1820) und dem zweiten Drain (1830) ;
- wobei das MOS-Bauelement ferner eine dielektrische Schicht (1850) umfasst, die über der oberen Oberfläche der ersten Wanne angeordnet und mit dem Abstand ausgerichtet ist; und ein zweites Gate (1855), das über der dielektrischen Schicht angeordnet und mit dem Abstand (1845) ausgerichtet ist,
- wobei das MOS-Bauelement ferner eine erste Seitenwand (1870) und eine zweite Seitenwand (1870) umfasst, beide vom zweiten Leitfähigkeitstyp und innerhalb der ersten Wanne (1810) definiert und beide sind mit einem gegenüberliegenden Ende des unteren Gates (1835) verbunden, das untere Gate und die beiden Seitenwände definieren eine zweite Wanne (1870) innerhalb der ersten Wanne und
- wobei die erste Source (1820), der erste und zweite Drain (1825, 1830) und das erste Gate (1840) alle innerhalb der zweiten Wanne angeordnet sind,
- wobei sich mindestens eine Seitenwand (1870) bis zur oberen Oberfläche (1815) erstreckt und
- wobei das erste Gate (1840) und das untere Gate (1835) einen Dual-Gate-JFET bilden.

## Revendications

1. Dispositif MOS comprenant :
- un substrat (1805) comportant un premier caisson (1810) d'un premier type de conductivité défini dans le substrat,
- le caisson ayant une surface supérieure (1815) et comportant, définis dans le premier caisson : une région du deuxième type de conductivité formant une grille inférieure (1835), une première source (1820) du premier type de conductivité, un premier drain (1825) du premier type de conductivité, un deuxième drain (1830) du premier type de conductivité entre le premier drain et la première source, une région du deuxième type de conductivité formant une première grille (1840) disposée à la surface supérieure et entre le premier drain et le deuxième drain, un premier canal (1860) du premier type de conductivité défini entre la grille inférieure et la première grille, dans lequel la grille inférieure est placée sous le premier canal, le premier canal fournissant en utilisation une conduction entre le premier drain (1825) et le deuxième drain (1830), un espace (1845) entre la première source et le deuxième drain, et un deuxième canal (1885) du deuxième type de conductivité disposé dans le premier caisson (1810), les premier et deuxième canaux ayant des types de dopage contraires, le deuxième canal fournissant en utilisation une conduction entre la première source (1820) et le deuxième drain (1830) ;
- dans lequel le dispositif MOS comprend en outre une couche diélectrique (1850) disposée au-dessus de la surface supérieure du premier caisson et alignée avec l'espace ; et une deuxième grille (1855) disposée au-dessus de la couche diélectrique et alignée avec l'espace (1845),
- dans lequel le dispositif MOS comprend en outre une première paroi latérale (1870) et une deuxième paroi latérale (1870) toutes deux du deuxième type de conductivité et définies dans le premier caisson (1810) et toutes deux reliées à une extrémité opposée de la grille inférieure (1835), la grille inférieure et les deux parois latérales définissant un deuxième caisson (1870) dans le premier caisson et
- dans lequel la première source (1820), les premier et deuxième drains (1825, 1830) et la première grille (1840) sont tous disposés dans le deuxième caisson,
- dans lequel au moins une paroi latérale (1870) s'étend jusqu'à la surface supérieure (1815) et
- dans lequel la première grille (1840) et la grille inférieure (1835) forment une double grille d'un transistor JFET.
